# DEMANDE DE BREVET EUROPEEN

(11) **EP 4 044 251 A1**
(43) Date de publication de la demande: **17.08.2022**
(21) Numéro de dépôt: 22155386.0
(22) Date de dépôt: 07.02.2022
(51) Int. Cl.: H01L 29/778, H01L 29/06, H01L 29/40, H01L 29/423, H01L 21/336, H01L 29/10, H01L 29/417, H01L 29/20

(54) **TRANSISTOR**

(30) Priorité: 16.02.2021 FR 2101480
(71) Demandeur: Commissariat à l'Energie Atomique et aux Energies Alternatives, 75015 Paris (FR)
(72) Inventeur: MOHAMAD, Blend, 38054 GRENOBLE CEDEX 09 (FR); ESCOFFIER, René, 38054 GRENOBLE CEDEX 09 (FR)
(74) Mandataire: Cabinet Beaumont

(57) **Abrégé**

La présente description concerne un dispositif (300) comportant un premier transistor (302), dont une région (110G) de grille pénètre partiellement dans une couche (104) en nitrure de gallium, et un deuxième transistor (304) situé à l'intérieur de la région de grille du premier transistor.

## Description

### Domaine technique

La présente description concerne de façon générale les dispositifs électroniques. La présente description concerne plus particulièrement les transistors à haute mobilité électronique (« High-Electron-Mobility Transistor » - HEMT, en anglais), ou transistors HEMT, normalement bloqués à base de nitrure de gallium (GaN) et les procédés de fabrication de tels transistors.

### Technique antérieure

Des transistors HEMT normalement bloqués à base de nitrure de gallium sont couramment utilisés dans des applications de conversion d'énergie électrique, pour des puissances typiquement comprises entre quelques milliwatts et plusieurs dizaines de watts. Il existe plusieurs types de transistors HEMT normalement bloqués, notamment des transistors HEMT comportant une grille isolée de type métal-isolant-semiconducteur (« Metal-Insulator-Semiconductor » - MIS, en anglais), ou transistors MIS-HEMT. De tels transistors possèdent généralement une forte résistance à l'état passant, ce qui nuit à leurs performances.

### Résumé de l'invention

Il existe un besoin d'améliorer les transistors à grille isolée et à haute mobilité électronique normalement bloqués à base de nitrure de gallium existants.

Un mode de réalisation pallie tout ou partie des inconvénients des transistors à haute mobilité électronique normalement bloqués à base de nitrure de gallium existants.

Un mode de réalisation prévoit un dispositif comportant un premier transistor, dont une région de grille pénètre partiellement dans une couche en nitrure de gallium, et un deuxième transistor situé à l'intérieur de la région de grille du premier transistor.

Selon un mode de réalisation, un matériau conducteur s'étend le long d'un premier flanc d'une portion verticale de la région de grille du premier transistor et contacte une première région du deuxième transistor, dopée d'un premier type de conductivité.

Selon un mode de réalisation, le matériau conducteur s'étend en outre le long d'un deuxième flanc, opposé au premier flanc, de la portion verticale de la région de grille du premier transistor et contacte une deuxième région du deuxième transistor, dopée du premier type de conductivité.

Selon un mode de réalisation, la deuxième région est séparée de la première région par une troisième région de canal du deuxième transistor non intentionnellement dopée ou dopée d'un deuxième type de conductivité opposé au premier type de conductivité.

Selon un mode de réalisation, le premier transistor comporte une première électrode de grille située au-dessus du deuxième transistor et isolée du deuxième transistor par une couche isolante.

Selon un mode de réalisation, le premier transistor comporte en outre des deuxième et troisième électrodes, situées de part et d'autre de la première électrode et pénétrant partiellement à l'intérieur de la couche en nitrure de gallium, la deuxième électrode étant plus proche de la première électrode que la troisième électrode et le premier flanc étant situé côté deuxième électrode.

Selon un mode de réalisation, le matériau conducteur s'étendant le long du premier flanc se prolonge jusqu'à la deuxième électrode.

Selon un mode de réalisation, la première électrode est plane et située sur et en contact avec la couche isolante, un premier flanc du deuxième transistor étant revêtu du matériau conducteur.

Selon un mode de réalisation, le deuxième transistor occupe la portion verticale de la région de grille du premier transistor.

Selon un mode de réalisation, la première électrode pénètre partiellement à l'intérieur de la couche en nitrure de gallium, un premier flanc de la première électrode étant revêtu de la couche isolante et du matériau conducteur.

Selon un mode de réalisation, le deuxième transistor est situé dans une partie inférieure de la région de grille du premier transistor.

Un mode de réalisation prévoit un procédé de fabrication d'un dispositif tel que décrit, le procédé comprenant les étapes suivantes :
a) former une tranchée à l'intérieur d'une couche en nitrure de gallium ;
b) revêtir un premier flanc de la tranchée d'une couche conductrice ;
c) former le deuxième transistor à l'intérieur de la tranchée ;
d) déposer une couche isolante revêtant la couche conductrice et le deuxième transistor ; et
e) former une première électrode de grille du premier transistor au-dessus du deuxième transistor.

Selon un mode de réalisation, à l'étape b), un deuxième flanc de la tranchée, opposé au premier flanc, est revêtu de la couche conductrice.

Selon un mode de réalisation, à l'étape c), le deuxième transistor remplit partiellement la tranchée.

Selon un mode de réalisation, à l'étape c), le deuxième transistor comble la tranchée.

### Brève description des dessins

Ces caractéristiques et avantages, ainsi que d'autres, seront exposés en détail dans la description suivante de modes de réalisation et modes de mise en œuvre particuliers faite à titre non limitatif en relation avec les figures jointes parmi lesquelles :
la figure 1 est une vue en coupe, schématique et partielle, d'un exemple de transistor ;
la figure 2 est un schéma électrique équivalent au transistor de la figure 1 ;
la figure 3 est une vue en coupe, schématique et partielle, d'un dispositif comportant un transistor selon un premier mode de réalisation ;
la figure 4 est une vue en coupe, schématique et partielle, d'un dispositif comportant un transistor selon un deuxième mode de réalisation ;
la figure 5 est une vue en coupe, schématique et partielle, d'un dispositif comportant un transistor selon un troisième mode de réalisation ;
la figure 6 est une vue en coupe, schématique et partielle, d'un dispositif comportant un transistor selon un quatrième mode de réalisation ;
la figure 7 est une vue en coupe, schématique et partielle, illustrant une étape d'un mode de mise en œuvre d'un procédé de réalisation du dispositif de la figure 6 ;
la figure 8 est une vue en coupe, schématique et partielle, illustrant une autre étape du mode de mise en œuvre du procédé de réalisation du dispositif de la figure 6 ;
la figure 9 est une vue en coupe, schématique et partielle, illustrant encore une autre étape du mode de mise en œuvre du procédé de réalisation du dispositif de la figure 6 ;
la figure 10 est une vue en coupe, schématique et partielle, illustrant encore une autre étape du mode de mise en œuvre du procédé de réalisation du dispositif de la figure 6 ;
la figure 11 est une vue en coupe, schématique et partielle, illustrant encore une autre étape du mode de mise en œuvre du procédé de réalisation du dispositif de la figure 6 ;
la figure 12 est une vue en coupe, schématique et partielle, illustrant une variante du mode de mise en œuvre du procédé de réalisation du dispositif de la figure 6 ;
la figure 13 est une vue en coupe, schématique et partielle, illustrant encore une autre étape du mode de mise en œuvre du procédé de réalisation du dispositif de la figure 6 ; et
la figure 14 est une vue en coupe, schématique et partielle, illustrant encore une autre étape du mode de mise en œuvre du procédé de réalisation du dispositif de la figure 6.

### Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés. En particulier, les applications et dispositifs susceptibles de tirer profit des transistors décrits ne sont pas détaillés, les modes de réalisation et modes de mise en œuvre décrits étant compatibles avec les applications et dispositifs usuels comportant des transistors normalement bloqués à haute mobilité électronique à base de nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Dans la description qui suit, sauf précision contraire, les termes isolant et conducteur signifient respectivement électriquement isolant et électriquement conducteur.

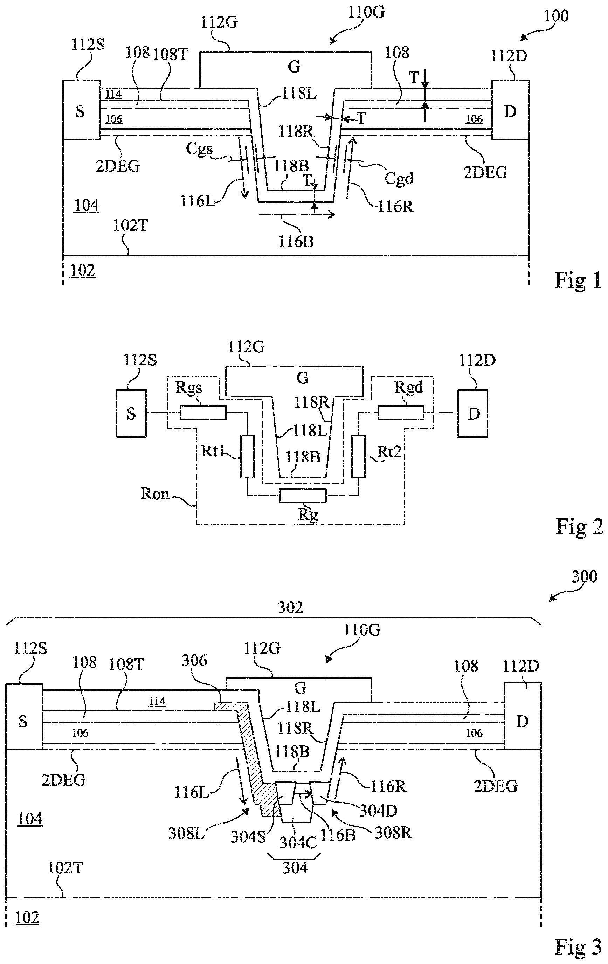

La figure 1 est une vue en coupe, schématique et partielle, d'un exemple de transistor 100 à haute mobilité électronique (« High-Electron-Mobility Transistor » - HEMT, en anglais), ou transistor HEMT. Le transistor HEMT 100 est, dans cet exemple, normalement bloqué.

Dans l'exemple représenté, le transistor HEMT 100 est formé sur un substrat 102. Le substrat 102 est par exemple une plaquette, ou un morceau de plaquette, dont seule une partie est représentée en figure 1. À titre d'exemple, le substrat 102 est en un matériau semiconducteur, par exemple le silicium, ou en verre, en saphir, etc.

Dans l'orientation de la figure 1, une couche 104 revêt une face supérieure 102T du substrat 102. À titre d'exemple, la couche 104 est en nitrure de gallium (GaN), par exemple en nitrure de gallium intrinsèque c'est-à-dire non dopé de manière intentionnelle.

Dans l'exemple représenté, une autre couche 106 revêt une face supérieure de la couche 104. À titre d'exemple, la couche 106 est en nitrure d'aluminium-gallium (AlGaN).

Dans l'exemple représenté, encore une autre couche 108 revêt une face supérieure de la couche 106. À titre d'exemple, la couche 108 est en nitrure de silicium (SiN).

Le transistor 100 comporte une région 110G de grille. La région 110G de grille du transistor 100 est dite encastrée (« recessed », en anglais) dans la couche 104 en nitrure de gallium. Plus précisément, dans l'exemple représenté, la région 110G de grille s'étend verticalement, depuis une face supérieure 108T de la couche 108, en direction de la face supérieure 102T du substrat 102. Chaque couche 106, 108 comporte ainsi deux parties disjointes, situées de part et d'autre de la région 110G de grille.

Dans l'exemple représenté, la région 110G de grille du transistor 100 comporte une électrode 112G de grille (G). L'électrode 112G présente une section en forme de T, dont une portion verticale traverse les couches 108 et 106 et pénètre partiellement dans l'épaisseur de la couche 104. En outre, une portion horizontale du T formé par l'électrode 112G de grille s'étend au-dessus de la couche 108.

Dans l'exemple représenté, les flancs de la portion verticale du T formé par l'électrode 112G de grille sont inclinés de telle sorte qu'ils se rapprochent l'un de l'autre en bas de l'électrode 112G. Cela permet de faciliter le passage des électrons d'un côté à l'autre de l'électrode 112G.

L'électrode 112G de grille est en un matériau conducteur. À titre d'exemple, l'électrode 112G est en un métal ou en un alliage métallique, par exemple un alliage à base de nitrure de titane (TiN) et de tungstène (W).

Dans l'exemple représenté, encore une autre couche 114 isole l'électrode 112G des couches 104, 106 et 108. La couche 114 est en un matériau isolant. À titre d'exemple, la couche 114 est en alumine (Al₂O₃).

La couche isolante 114 revêt les faces latérales et la face inférieure de la portion verticale du T formé par l'électrode 112G. Cette face inférieure est également appelée fond de l'électrode 112G. En outre, la couche isolante 114 se prolonge latéralement de part et d'autre de la portion verticale et sous la portion horizontale du T formé par l'électrode 112G. La couche 114 s'étend sur et en contact avec la face supérieure 108T de la couche 108.

Dans l'exemple représenté, la portion horizontale du T formé par l'électrode 112G s'étend sur et en contact avec des parties de la couche 114. Ces parties de la couche 114 sont ainsi intercalées verticalement entre la couche 108 et la portion horizontale du T formé par l'électrode 112G.

Les parties de la couche 114 situées à l'aplomb de l'électrode 112G de grille sont considérées comme appartenant à la région 110G de grille du transistor 100.

Dans l'exemple représenté, la couche isolante 114 présente une épaisseur T sensiblement constante. À titre d'exemple, l'épaisseur T de la couche 114 est égale à environ 30 nm, à plus ou moins 20 % près. Cela permet d'isoler convenablement l'électrode 112G de grille par rapport à la couche 104 en nitrure de gallium tout en conservant une tension Vth de seuil relativement faible, par exemple de l'ordre de 1 V.

Le transistor 100 comporte en outre deux autres électrodes 112S et 112D. Les électrodes 112S et 112D sont situées de part et d'autre de l'électrode 112G de grille du transistor 100. L'électrode 112S est par exemple plus proche de l'électrode 112G de grille que l'électrode 112D. Les électrodes 112S, 112G et 112D du transistor 100 s'étendent perpendiculairement au plan de coupe de la figure 1, le long d'une direction communément appelée largeur (W) du transistor 100. Le plan de coupe de la figure 1 est ainsi orienté parallèlement à une autre direction communément appelée longueur (L) du transistor 100 et perpendiculairement à la face supérieure 108T de la couche 108.

À titre d'exemple :
- l'électrode 112S est séparée de l'électrode 112G par une distance comprise entre 1 et 2 µm, par exemple égale à environ 1 µm ; et
- l'électrode 112D est séparée de l'électrode 112G par une distance comprise entre 10 et 20 µm, par exemple égale à environ 10 µm, dans le but d'assurer une tenue en tension allant par exemple jusqu'à 1 000 V (le champ électrique maximum dans le GaN est théoriquement de 2 MV/cm, mais il est en pratique limité par exemple à 1 MV/cm par la qualité de la couche 104 en GaN).

Dans l'exemple représenté, les électrodes 112S et 112D s'étendent chacune verticalement, depuis la face supérieure de la couche isolante 114, en direction de la face supérieure 102T du substrat 102. Plus précisément, dans l'exemple représenté, les électrodes 112S et 112D traversent chacune les couches 114, 108 et 106 et pénètrent partiellement dans l'épaisseur de la couche 104.

Les électrodes 112S et 112D sont chacune en un matériau conducteur, par exemple un métal ou un alliage métallique. Les électrodes 112S et 112D sont par exemple en le même matériau que l'électrode 112G.

À titre d'exemple, lorsque le transistor 100 est en fonctionnement, l'électrode 112S est une électrode de source (S) et l'électrode 112D est une électrode de drain (D). L'électrode 112D étant plus éloignée de l'électrode 112G que l'électrode 112S, cela permet d'appliquer un potentiel élevé, par exemple de l'ordre de 650 V, sur l'électrode 112D sans risque de claquage du transistor 100, les électrodes 112S et 112G étant généralement soumises à des potentiels de l'ordre de quelques volts.

Dans le transistor HEMT 100, un gaz d'électrons bidimensionnel (2DEG), symbolisé en figure 1 par un trait en pointillé, se forme à l'intérieur de la couche 104 à proximité d'une interface entre les couches 104 et 106. Les électrodes 112S et 112D du transistor HEMT 100 sont chacune en contact avec le gaz d'électrons bidimensionnel 2DEG.

Dans l'exemple représenté où le transistor HEMT 100 est normalement bloqué, le gaz d'électrons bidimensionnel 2DEG est interrompu par la région 110G de grille. Plus précisément, dans cet exemple, le gaz d'électrons bidimensionnel 2DEG est discontinu et comporte deux parties situées de part et d'autre de la région 110G de grille du transistor 100 (à gauche et à droite de la région 110G, dans l'orientation de la figure 1).

Lorsqu'une tension Vgs sensiblement nulle est appliquée entre l'électrode 112G de grille et l'électrode 112S de source, la région 110G de grille encastrée dans la couche 104 en nitrure de gallium empêche les électrons de circuler entre l'électrode 112S de source et l'électrode 112D de drain. Le transistor 100 est alors dans un état bloqué.

En revanche, lorsque la tension Vgs appliquée entre l'électrode 112G de grille et l'électrode 112S de source excède la tension Vth de seuil du transistor 100, des électrons peuvent circuler entre l'électrode 112S de source et l'électrode 112D de drain. Le transistor 100 est alors dans un état passant.

À l'état passant, les électrons circulent d'une partie à l'autre du gaz d'électrons bidimensionnel 2DEG en contournant la région 110G de grille. Plus précisément, lorsque le transistor 100 est passant et soumis à une tension de polarisation appliquée entre son drain D et sa source S, les électrons empruntent alors, pour circuler d'un côté à l'autre de la grille G, un chemin de conduction situé à l'intérieur de la couche 104 le long d'une interface entre la couche 104 et la couche isolante 114.

Le chemin de conduction emprunté par les électrons pour contourner la région 110G de grille est symbolisé, en figure 1, par des flèches 116L, 116B et 116R. Plus précisément, dans l'orientation de la figure 1 :
- la flèche 116L symbolise un chemin emprunté par les électrons pour descendre le long d'un premier flanc 118L de l'électrode 112G de grille situé côté électrode 112S de source ;
- la flèche 116B symbolise un chemin emprunté par les électrons pour se déplacer horizontalement sous le fond 118B de l'électrode 112G de grille ; et
- la flèche 116R symbolise un chemin emprunté par les électrons pour remonter le long d'un deuxième flanc 118R de l'électrode 112G de grille opposé au flanc 118L, situé côté électrode 112D de drain.

Bien que cela n'ait pas été représenté en figure 1, le transistor 100 peut en outre comporter d'autres éléments tels que des couches isolantes revêtant la couche 114 et/ou une partie de l'électrode 112G de grille, des plaques de champ (« field plates », en anglais), des éléments de reprise de contact, etc.

Un inconvénient des transistors HEMT semblables au transistor 100 tient au fait qu'ils présentent, à l'état passant, une résistance drain-source Ron élevée qui dégrade fortement leurs performances électriques. Cela est notamment dû à des résistances associées aux chemins de conduction 116L, 116B et 116R empruntés par les électrons pour contourner la région 110G de grille.

Afin de diminuer la résistance Ron à l'état passant du transistor 100, on pourrait penser prévoir une structure dans laquelle la couche isolante 114 serait omise et où l'électrode 112G de grille ne pénétrerait pas à l'intérieur de la couche 104 en nitrure de gallium. Cela reviendrait par exemple à faire en sorte que l'électrode 112G s'arrête dans l'épaisseur de la couche 106, avant l'interface entre la couche 106 et la couche 104. On formerait ainsi une grille de type Schottky, qui permettrait d'interrompre ou d'atténuer localement le gaz d'électrons bidimensionnel 2DEG à l'aplomb de l'électrode 112G de grille de sorte à obtenir un transistor normalement bloqué. Toutefois, cela ne permettrait pas d'atteindre une tension Vth de seuil supérieure à environ 1 V, ce qui s'avère problématique pour la plupart des applications utilisant des transistors HEMT.

On pourrait en outre penser réaliser une structure dans laquelle la région 110G de grille ne serait pas encastrée dans les couches 108, 106 et 104. Cela reviendrait par exemple à former l'électrode 112G de grille sur et en contact avec la couche 108. À titre d'exemple, on pourrait notamment prévoir une implantation d'ions fluor (F⁺) dans la couche 106, à l'aplomb de l'électrode 112G de grille, ce qui aurait pour effet d'atténuer ou d'interrompre le gaz d'électrons bidimensionnel 2DEG sous la grille du transistor 100. Cela tendrait toutefois à compliquer un contrôle de la tension Vth de seuil.

On pourrait alternativement prévoir d'omettre la couche 114, de réaliser l'électrode 112G de grille au-dessus de la couche 108 et d'intercaler une couche en nitrure de gallium dopé de type P (p-GaN) entre l'électrode de grille et la couche 108. Toutefois, cela ne permettrait pas d'atteindre une tension Vth de seuil suffisamment élevée pour les applications visées.

On pourrait par ailleurs penser réduire la largeur de la face inférieure 118B de la portion verticale du T formé par la région 110G de grille, de manière à réduire la longueur du chemin de conduction horizontal 116B. Toutefois, cela ne permettrait pas de diminuer significativement la résistance Ron à l'état passant du transistor 100.

Un autre inconvénient des transistors HEMT semblables au transistor 100 tient au fait qu'ils présentent, de part et d'autre de la région 110G de grille, des capacités Cgs et Cgd parasites. La capacité Cgs correspond plus précisément à une capacité parasite entre la partie du gaz d'électrons bidimensionnel 2DEG située du côté de l'électrode 112S de source (la partie gauche du gaz d'électrons bidimensionnel 2DEG, dans l'orientation de la figure 1) et le flanc 118L de l'électrode 112G de grille. La capacité Cgd correspond plus précisément à une autre capacité parasite entre la partie du gaz d'électrons bidimensionnel 2DEG située du côté de l'électrode 112D de drain (la partie droite du gaz d'électrons bidimensionnel 2DEG, dans l'orientation de la figure 1) et le flanc 118R de l'électrode 112G de grille. Les capacités Cgs et Cgd nuisent au fonctionnement du transistor 100 notamment à des fréquences de commutation élevées, par exemple comprises entre une centaine de kilohertz et plusieurs mégahertz.

La figure 2 est un schéma électrique équivalent au transistor 100 de la figure 1.

Comme illustré en figure 2, la résistance Ron à l'état passant du transistor 100, entre sa borne 112S de source et sa borne 112D de drain, peut être décomposée en :
- une résistance Rgs, correspondant à un chemin de conduction empruntant la partie du gaz d'électrons bidimensionnel 2DEG située entre l'électrode 112S de source et l'électrode 112G de grille ;
- une autre résistance Rt1, correspondant au chemin de conduction 116L emprunté par les électrons pour descendre le long du flanc 118L de l'électrode 112G ;
- encore une autre résistance Rg, correspondant au chemin de conduction 116B emprunté par les électrons pour se déplacer horizontalement sous le fond 118B de l'électrode 112G ;
- encore une autre résistance Rt2 correspondant au chemin de conduction 116R emprunté par les électrons pour remonter le long du flanc 118R de l'électrode 112G ; et
- encore une autre résistance Rgd, correspondant à un chemin de conduction empruntant la partie du gaz d'électrons bidimensionnel 2DEG située entre l'électrode 112G de grille et l'électrode 112D de drain.

Les résistances Rgs, Rt1, Rg, Rt2 et Rgd, dont l'association en série équivaut à la résistance Ron (si l'on néglige les résistances de contact ohmique de source et de drain), nuisent au fonctionnement du transistor 100 comme cela a été exposé précédemment en relation avec la figure 1. En particulier, la résistance Rt1 présente généralement une valeur importante, qui modifie la résistance à l'état passant du transistor 100.

La figure 3 est une vue en coupe, schématique et partielle, d'un dispositif 300 comportant un premier transistor 302 selon un premier mode de réalisation.

Le transistor 302 de la figure 3 comprend des éléments communs avec le transistor 100 de la figure 1. Ces éléments communs ne seront pas décrits à nouveau ci-après. En particulier, le transistor 302 comporte, à l'instar du transistor 100, le substrat 102 dont la face supérieure 102T est revêtue de la couche 104 en nitrure de gallium, de la couche 106 en nitrure d'aluminium-gallium et de la couche 108 en nitrure de silicium. Le transistor 302 comporte en outre la région 110G de grille et les électrodes 112S, 112G et 112D précédemment décrites en relation avec le transistor 100 de la figure 1.

Selon ce mode de réalisation, le dispositif 300 comporte en outre un deuxième transistor 304 situé à l'intérieur de la région 110G de grille du premier transistor 302. Dans l'exemple représenté, le transistor 304 est situé sous l'électrode 112G de grille du transistor 302. Le transistor 304 est par exemple isolé de l'électrode 112G de grille du transistor 302 par la couche 114 isolante. La couche 114 est par exemple interposée entre l'électrode 112G de grille du transistor 302 et le transistor 304.

Dans l'exemple représenté, le transistor 304 comporte une première région 304S de source, dopée d'un premier type de conductivité, et une deuxième région 304D de drain, dopée du premier type de conductivité. La première région 304S de source est par exemple séparée de la deuxième région 304D de drain par une troisième région 304C de canal. La troisième région 304C de canal est par exemple en un matériau semiconducteur intrinsèque, c'est-à-dire non dopé de manière intentionnelle, ou en un matériau semiconducteur faiblement dopé d'un deuxième type de conductivité opposé au premier type de conductivité. Le deuxième transistor 304 du dispositif 300 est, de préférence, un transistor MOS (de l'anglais "Metal-Oxide-Semiconductor" - métal oxyde semiconducteur) à base de silicium, ou transistor MOS silicium. À titre d'exemple, la région 304C de canal est en silicium polycristallin (poly-Si) intrinsèque et les régions 304S de source et 304D de drain du transistor 304 sont en silicium polycristallin dopé de type N.

Dans l'exemple représenté, le flanc 118L de l'électrode 112G de grille est revêtu de la couche 114 isolante et d'un matériau conducteur 306. Le matériau conducteur 306 revêt intégralement un flanc de la région 304S de source situé côté électrode 112S de source du premier transistor 302. En outre, dans l'exemple représenté, le matériau 306 revêt partiellement un flanc de la région 304C de canal situé côté électrode 112S de source du premier transistor 302. Dans cet exemple, le fond 118B et le flanc 118R de l'électrode 112G de grille du transistor 302 sont également revêtus de la couche 114 isolante, mais ne sont pas revêtus du matériau conducteur 306.

Dans l'exemple représenté, le matériau conducteur 306 s'étend sur et en contact avec la face supérieure 108T de la couche 108. Dans cet exemple, le matériau conducteur 306 se prolonge en direction de l'électrode 112S de source à l'aplomb de l'électrode 112G de grille sans contacter l'électrode 112S de source. Le matériau conducteur revêt en outre un flanc du transistor 304 situé approximativement dans le prolongement du flanc 118L de l'électrode 112G de grille du transistor 302, côté électrode 112S de source. Dans l'exemple représenté, le matériau conducteur 306 revêtant le flanc 118L de l'électrode 112G contacte la région 304S de source du transistor 304.

À titre d'exemple, le matériau conducteur 306 présente une épaisseur comprise entre 5 et 10 nm.

Le matériau conducteur 306 est par exemple un métal, un alliage métallique ou un semiconducteur dopé de type N. À titre d'exemple, le matériau conducteur 306 est l'aluminium (Al), l'or (Au), le cuivre (Cu) ou le nitrure de titane (TiN).

Dans l'exemple représenté, la région 110G de grille présente des épaulements, ou marches. Plus précisément, le matériau conducteur 306 situé côté flanc 118L de l'électrode 112G de grille présente un épaulement 308L. Un épaulement 308R similaire est situé côté flanc 118R de l'électrode 112G de grille, au niveau de la région 304D de drain du transistor 304.

Dans cet exemple, les épaulements 308L et 308R sont situés dans la couche 104 de nitrure de gallium, à proximité du fond 118B de l'électrode 112G de grille. Par rapport au transistor 100 de la figure 1, cela permet un lissage d'un champ électrique issu d'une polarisation de l'électrode 112D de drain par rapport à l'électrode 112G de grille. En d'autres termes, chaque épaulement 308L, 308R joue un rôle analogue à celui d'une plaque de champ.

En variante, les épaulements 308L et 308R sont omis.

Dans le dispositif 300, la région 304C de canal du transistor 304 est en inversion lorsque la tension Vgs entre l'électrode 112G de grille et l'électrode 112S de source excède la tension Vth de seuil du transistor 304. Les électrons qui transitent depuis la source S vers le drain D du transistor 302 circulent d'abord via une première portion de gaz d'électrons 2DEG située à l'interface entre les couches 104 et 106, traversent alors ensuite le matériau conducteur 306 via le chemin 116L, puis les régions 304S de source, 304C de canal et 304D de drain du transistor 304. Pour finir, les électrons remontent par le chemin 116R le long du flanc 118R, puis rejoignent le drain 112D du transistor 302 via une deuxième portion de gaz d'électrons 2DEG située à l'interface entre les couches 104 et 106. Le chemin 116B de conduction emprunté par les électrons pour se déplacer horizontalement sous le fond 118B de l'électrode 112G de grille est dans ce cas situé dans la région 304C de canal, entre les régions 304S de source et 304D de drain du transistor 304, et non plus dans la couche 104 de nitrure de gallium comme dans le cas du transistor 100 de la figure 1.

Le dispositif 300 peut être considéré comme étant équivalent à un transistor MOS silicium 304 en série avec un transistor HEMT 302 à grille verticale. Une mise à l'état passant d'un transistor global, correspondant à l'association en série des transistors 304 et 302, est ainsi commandée par une mise à l'état passant simultanée du transistor MOS silicium 304 et du transistor HEMT vertical 302. Le fait que le flanc 118R de l'électrode de grille 112G soit dépourvu du matériau conducteur 306 permet avantageusement d'éviter d'appliquer un potentiel de drain, présent à l'électrode 112D, directement sur la région 304D de drain du transistor MOS 304. On protège ainsi le transistor MOS 304 contre des tensions de drain élevées qui sont présentes avant que le gaz d'électrons 2DEG ne soit déplété entre le flanc 118R de la grille 112G et le drain 112D.

Un avantage du mode de réalisation du dispositif 300 exposé en relation avec la figure 3 tient au fait que le matériau conducteur 306 borde le flanc 118L de l'électrode 112G de grille. Cela permet aux électrons de circuler plus facilement autour de la région 110G de grille du transistor 302. Le matériau conducteur 306 permet notamment aux électrons de descendre plus facilement le long du flanc 118L. Dans le dispositif 300, la présence du matériau conducteur 306 le long du flanc 118L de l'électrode 112G permet plus précisément, par rapport au transistor 100 de la figure 1, d'éviter une chute de mobilité due à des états d'interface et à des niveaux de pièges près de l'interface entre la couche 104 et la région 110G de grille.

Le piégeage des électrons se traduit par exemple par un phénomène d'hystérésis, observable par exemple sur des courbes d'évolution d'un courant Id de drain en fonction de la tension Vgs appliquée entre les électrodes 112G de grille et 112S de source (courbes Id(Vgs)). Le piégeage provoque en outre une forte atténuation (« collapse », en anglais) du courant Id de drain après polarisation du transistor 100, observable par exemple sur des courbes du courant Id de drain en fonction d'une tension Vds appliquée entre les électrodes 112D de drain et 112S de source (courbes Id(Vds)). Dans le cas du dispositif 300, le phénomène de piégeage des électrons est fortement réduit le long du chemin de conduction 116L car les électrons circulent préférentiellement dans le matériau conducteur 306 plutôt que dans la couche 104.

Un autre avantage de ce mode de réalisation provient de la présence du deuxième transistor 304 à l'intérieur de la région 110G de grille du premier transistor 302. Cela permet un meilleur contrôle de la tension Vth de seuil du dispositif 300. À titre d'exemple, le dispositif 300 présente une tension de seuil Vth supérieure à environ 1,5 V.

Encore un autre avantage du dispositif 300 tient au fait que la résistance Rt1 (figure 2) du transistor 302 est sensiblement nulle en raison de la présence du matériau conducteur 306 le long du flanc 118L de l'électrode 112G de grille. La résistance Ron à l'état passant du transistor 302 est ainsi plus faible que celle du transistor 100. Dans le transistor 100 de la figure 1, les électrons présentent une faible mobilité le long du chemin de conduction 116L. À titre d'exemple, la mobilité des électrons dans le transistor 100, c'est-à-dire en l'absence de matériau conducteur 306, est de l'ordre de 200 cm²/(V.s) le long du chemin de conduction 116L et d'environ 2 000 cm²/(V.s) dans le gaz d'électrons bidimensionnel 2DEG. Le fait de prévoir le matériau conducteur 306 du côté du flanc 118L de l'électrode 112G de grille du transistor 302 permet d'obtenir, le long du chemin de conduction 116L, une mobilité électronique très supérieure à celle du transistor 100, par exemple sensiblement égale à la mobilité dans le gaz d'électrons bidimensionnel 2DEG.

On aurait pu penser prévoir un montage de type cascode, dans lequel le deuxième transistor 304 serait associé en série avec le premier transistor 302, le drain du transistor 304 étant connecté à la source du transistor 302, et dans lequel la source du transistor 304 serait connectée à la grille du transistor 302. Un tel dispositif occuperait toutefois une surface environ 20 % plus importante que celle occupée par le dispositif 300, dans lequel le transistor 304 est intégré dans la région 110G de grille du transistor 302. Le dispositif 300 ne nécessite notamment pas de prévoir une puce à base de silicium combinée à une puce à base de nitrure de gallium. Le mode de réalisation décrit en relation avec la figure 3 permet ainsi une réduction de taille avantageuse.

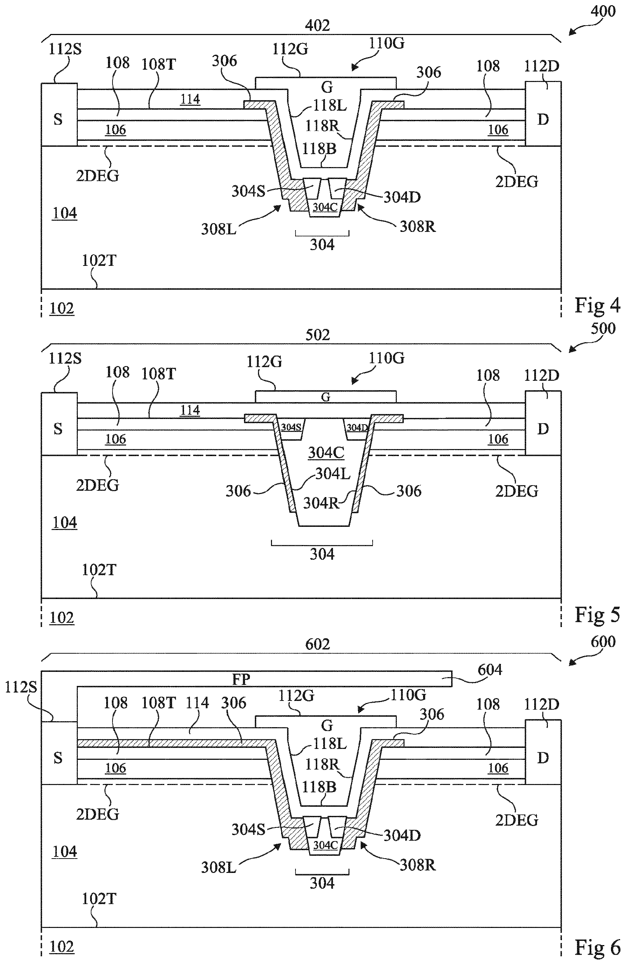

La figure 4 est une vue en coupe, schématique et partielle, d'un dispositif 400 comportant un transistor 402 selon un deuxième mode de réalisation. Le transistor 402 du dispositif 400 de la figure 4 comprend des éléments communs avec le transistor 302 du dispositif 300 de la figure 3. Ces éléments communs ne seront pas décrits à nouveau ci-après.

Le transistor 402 diffère du transistor 302 principalement en ce que le flanc 118R de l'électrode 112G de grille est en outre revêtu du matériau conducteur 306.

Plus précisément, dans l'exemple représenté :
- la couche isolante 114 s'étend en contact avec l'électrode 112G le long du flanc 118R ; et
- le matériau conducteur 306 s'étend en contact avec la couche isolante 114 le long du flanc 118R de l'électrode 112G.

Dans cet exemple, le matériau conducteur 306 forme deux parties de couches disjointes, situées de part et d'autre du fond 118B de l'électrode 112G. Le matériau conducteur 306 situé du côté du flanc 118L est séparé du matériau conducteur 306 situé du côté du flanc 118R par le transistor 304. Dans l'exemple représenté, le matériau conducteur 306 revêtant le flanc 118R de l'électrode 112G contacte la région 304D de drain du transistor 304.

Dans l'exemple représenté, la région 110G de grille présente les épaulements 308L et 308R pour les mêmes raisons que précédemment. Dans cet exemple, l'épaulement 308R est formé dans le matériau conducteur 306 situé côté flanc 118R de l'électrode 112G de grille.

En variante, les épaulements 308L et 308R sont omis.

Un avantage du dispositif 400 tient au fait que le matériau conducteur 306 borde le flanc 118R de l'électrode 112G de grille du transistor 402. Cela permet aux électrons de circuler plus facilement autour de la région 110G de grille. Plus précisément, le matériau conducteur 306 permet aux électrons de remonter plus facilement le long du flanc 118R. Dans le dispositif 400, la présence du matériau conducteur 306 le long du flanc 118R de l'électrode 112G permet, par rapport au dispositif 300 de la figure 3, d'éviter encore davantage la chute de mobilité due aux états d'interface et aux niveaux de pièges près de l'interface entre la couche 104 et la région 110G de grille.

Par rapport au dispositif 300 de la figure 3, la résistance Rt2 (figure 2) du dispositif 400 est sensiblement nulle en raison de la présence du matériau conducteur 306 le long du flanc 118R de l'électrode 112G de grille.

La résistance Ron à l'état passant du dispositif 400 est ainsi encore plus faible que celle du dispositif 300. Le fait de prévoir le matériau conducteur 306 du côté du flanc 118R de l'électrode 112G de grille du transistor 402 permet d'obtenir, le long du chemin de conduction 116R, une mobilité électronique par exemple sensiblement égale à la mobilité dans le gaz d'électrons bidimensionnel 2DEG.

La figure 5 est une vue en coupe, schématique et partielle, d'un dispositif 500 comportant un transistor 502 selon un troisième mode de réalisation. Le transistor 502 du dispositif 500 de la figure 5 comprend des éléments communs avec le transistor 402 du dispositif 400 de la figure 4. Ces éléments communs ne seront pas décrits à nouveau ci-après.

Le transistor 502 diffère du transistor 402 principalement en ce que l'électrode 112G de grille ne pénètre pas à l'intérieur des couches 108, 106 et 104. Dans l'exemple représenté, l'électrode 112G de grille est une électrode plane située sur et en contact avec la couche isolante 114. La couche isolante 114 est, dans cet exemple, une couche plane.

Par rapport au dispositif 400, la portion verticale du T formé par l'électrode 112G de grille est remplacée, dans le dispositif 500, par le transistor 302. Dans l'exemple représenté, le transistor 304 situé à l'intérieur de la région 112G de grille s'étend verticalement, depuis la face supérieure 108T de la couche 108, à travers les couches 108 et 106 et pénètre partiellement dans l'épaisseur de la couche 104. Avantageusement, la région 304C de canal traverse la couche 106 et pénètre partiellement dans la couche 104, les régions 304S de source et 304D de drain ne pénétrant pas dans la couche 104.

À titre d'exemple, le transistor 304 s'étend sous la couche 106 à une profondeur comprise entre 40 et 200 nm, par exemple égale à environ 50 nm.

Dans l'exemple représenté, le matériau conducteur 306 revêt un flanc 304L du transistor 304 situé côté électrode 112S de source du transistor 502. Le matériau conducteur 306 revêt en outre un autre flanc 304R du transistor 304 situé côté électrode 112D de drain du transistor 502. Le matériau conducteur 306 revêtant le flanc 304L contacte la région 304S de source du transistor 304. Le matériau conducteur 306 du flanc 304L revêt plus précisément des flancs de la région 304S de source et de la région 304C de canal situés côté électrode 112S. De façon analogue, le matériau conducteur 306 revêtant le flanc 304R contacte la région 304D de drain du transistor 304. Plus précisément, le matériau conducteur 306 du flanc 304R revêt des flancs de la région 304D de drain et de la région 304C de canal situés côté électrode 112D. Dans cet exemple, le matériau conducteur 306 revêtant le flanc 304R est séparé du matériau conducteur 306 revêtant le flanc 304L par le transistor 304. Les régions 304S de source et 304D de drain du transistor 304 s'étendent par exemple verticalement sous la couche isolante 114.

Dans l'exemple représenté, les épaulements 308L et 308R sont omis. Plus précisément, dans cet exemple, ni le matériau conducteur 306 situé côté flanc 118L de l'électrode 112G de grille, ni le matériau conducteur 306 situé côté flanc 118R de l'électrode 112G de grille, ne présente d'épaulement. En variante, le dispositif 400 présente des épaulements, par exemple similaires aux épaulements 308L et 308R des dispositifs 300 et 400.

Bien que cela n'ait pas été représenté en figure 5, le fond de la région 110G de grille peut être réalisé en oxyde de silicium (SiO₂).

Un avantage du dispositif 500 de la figure 5 réside dans sa facilité de réalisation, car les parties dopées 304S et 304D sont situées en surface et sont suffisamment éloignées pour faciliter un alignement de masques d'implantation.

La figure 6 est une vue en coupe, schématique et partielle, d'un dispositif 600 comportant un transistor 602 selon un quatrième mode de réalisation. Le transistor 602 de la figure 6 comprend des éléments communs avec le transistor 402 de la figure 4. Ces éléments communs ne seront pas décrits à nouveau ci-après.

Le transistor 602 diffère du transistor 402 principalement en ce que le matériau conducteur 306 situé du côté du flanc 118L de l'électrode 112G du transistor 602 est connecté à l'électrode 112S de source. Plus précisément, la partie de couche du matériau conducteur 306 située du côté du flanc 118L se prolonge, sur et en contact avec la face supérieure 108T de la couche 108, jusqu'à l'électrode 112S. La partie de la couche du matériau conducteur 306 située côté flanc 118L présente ainsi, au voisinage du fond 118B de l'électrode 112G, un potentiel sensiblement égal à celui de l'électrode 112S de source, par exemple la masse (0 V).

Dans l'exemple représenté, le dispositif 600 comporte une plaque de champ 604 (FP) de source. Dans cet exemple, la plaque de champ 604 contacte l'électrode 112S de source et s'étend horizontalement au-dessus de la région 110G de grille en direction de l'électrode 112D de drain. Bien que cela ne soit pas représenté en figure 6, la plaque de champ 604 est par exemple séparée de la couche isolante 114 et de l'électrode 112G de grille par une ou plusieurs autres couches isolantes.

Un avantage du mode de réalisation du dispositif 600 exposé ci-dessus en relation avec la figure 6 tient au fait que le matériau conducteur 306 s'étend depuis l'électrode 112S de source jusqu'au voisinage du fond 118B de l'électrode 112G de grille. Cela permet aux électrons de circuler plus facilement entre l'électrode 112S de source et le fond 118B de l'électrode 112G. Du fait que le matériau conducteur 306 s'étend jusqu'à l'électrode 112S, on obtient notamment un chemin de conduction plus favorable que celui passant par le gaz d'électrons bidimensionnel 2DEG situé dans la couche 104 en nitrure de gallium.

Par rapport au transistor 400 de la figure 4, la résistance Rgs du transistor 602 est sensiblement nulle en raison de la connexion entre le matériau conducteur 306 situé le long du flanc 118L de l'électrode 112G de grille et l'électrode 112S de source. Dans le cas du transistor 602, la prolongation du matériau conducteur 306 jusqu'à l'électrode 112S permet de limiter ou d'éviter des problèmes de contact ohmique entre le gaz d'électrons bidimensionnel 2DEG et le matériau conducteur 306 situé du côté du flanc 118L de l'électrode 112G de grille. Cela permet en outre un meilleur contrôle électrostatique entre grille et source, donc une plus grande efficacité de commande Vgs du transistor 602.

La résistance Ron à l'état passant du transistor 602 est ainsi encore plus faible que celle du transistor 402.

En variante, on peut prévoir d'omettre la partie de la couche du matériau conducteur 306 qui revêt le flanc 118R de l'électrode 112G et de conserver uniquement la partie de la couche du matériau conducteur 306 qui revêt le flanc 118L de l'électrode 112G et qui se prolonge jusqu'à l'électrode 112S. Cela revient par exemple, partant du dispositif 300 de la figure 3, à prolonger la partie de couche du matériau conducteur 306 située du côté du flanc 118L jusqu'à l'électrode 112S. Cette variante présente des avantages identiques ou analogues à ceux du dispositif 600 de la figure 6.

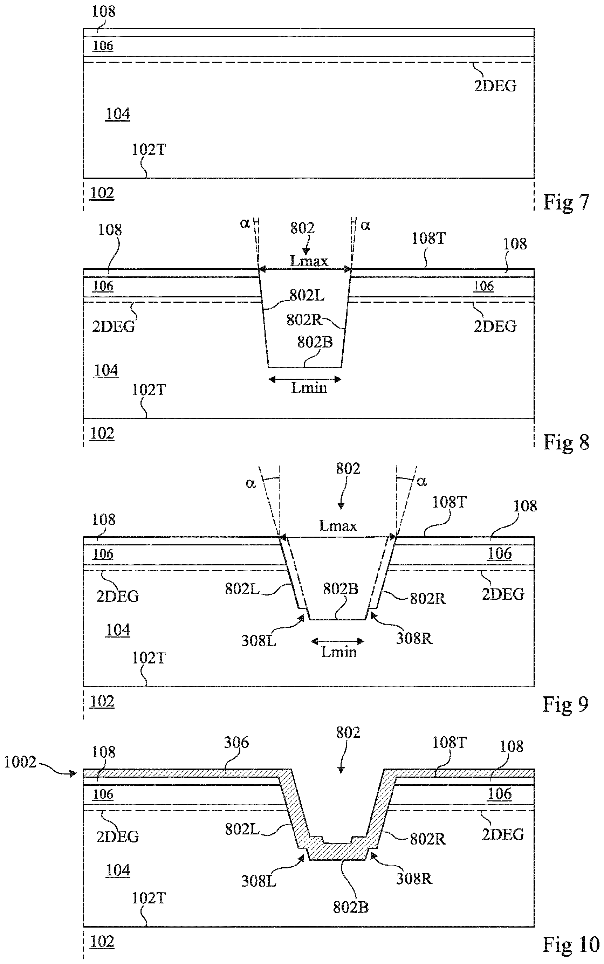

Les figures 7 à 14 ci-dessous illustrent des étapes successives d'un exemple d'un mode de mise en œuvre d'un procédé de réalisation du dispositif 600 de la figure 6.

La figure 7 est une vue en coupe, schématique et partielle, illustrant une étape du mode de mise en œuvre du procédé de réalisation du dispositif 600 de la figure 6.

Au cours de cette étape, la couche 104, la couche 106 et la couche 108 sont successivement réalisées, dans cet ordre, du côté de la face 102T du substrat 102. Plus précisément :
- la couche 104 s'étend de façon continue et sur toute la face 102T supérieure du substrat 102 ;
- la couche 106 s'étend de façon continue et sur toute la face supérieure de la couche 104 ; et
- la couche 108 s'étend de façon continue et sur toute la face supérieure de la couche 106.

Les couches 104, 106 et 108 sont par exemple réalisées par épitaxie. Bien que cela ne soit pas représenté en figure 7, une couche intermédiaire en nitrure d'aluminium peut être intercalée entre les couches 104 et 106. Le cas échéant, cela permet de favoriser l'épitaxie de la couche 106 en nitrure d'aluminium-gallium sur la couche 104 en nitrure de gallium par adaptation de paramètre de maille.

En figure 7, le gaz d'électrons bidimensionnel 2DEG s'étend latéralement et de façon continue dans la couche 104, sous l'interface entre les couches 104 et 106.

La figure 8 est une vue en coupe, schématique et partielle, illustrant une autre étape du mode de mise en œuvre du procédé de réalisation du dispositif 600 de la figure 6.

Au cours de cette étape, on réalise une tranchée 802 s'étendant verticalement en direction du substrat 102 depuis la face supérieure 108T de la couche 108. Plus précisément, dans l'exemple représenté, la tranchée 802 traverse les couches 108 et 106 et pénètre partiellement dans l'épaisseur de la couche 104. La tranchée 802 s'arrête dans la couche 104 et n'atteint pas la face supérieure 102T du substrat 102.

À titre d'exemple, la tranchée 802 est réalisée par gravure de couches atomiques (« Atomic Layer Etching » - ALE, en anglais).

Selon un mode de mise en œuvre, on fait en sorte que la tranchée 802 présente des parois latérales 802L et 802R, ou flancs, obliques. Plus précisément, on grave par exemple la tranchée 802 de sorte que ses parois latérales 802L et 802R forment chacune un angle α par rapport à une normale à la face supérieure 108T de la couche 108. À titre d'exemple, l'angle α formé par les parois 802L et 802R est compris entre 5° et 45°, par exemple égal à environ 10°.

Les parois latérales 802L et 802R sont inclinées de manière à ce que la tranchée 802 présente un profil évasé. Plus précisément, on fait en sorte que la tranchée 802 présente une ouverture (en haut, dans l'orientation de la figure 8) plus large que son fond 802B (en bas, dans l'orientation de la figure 8).

Les parois latérales 802L et 802R de la tranchée 802 constituent des flancs de la future région 110G de grille du transistor 602. Plus précisément :
- la paroi 802L constitue le flanc de la région 110G de grille situé côté électrode 112S de source ; et
- la paroi 802R, opposée à la paroi 802L, constitue le flanc de la région 110G de grille situé côté électrode 112D de drain.

Le fait de prévoir une tranchée 802 présentant des parois latérales 802L et 802R obliques permet, lorsque le dispositif 600 est à l'état passant, de faciliter le passage des électrons autour de la région 110G de grille. Cela permet, plus précisément, de faciliter la descente des électrons le long du flanc de la région 110G de grille situé côté électrode 112S, c'est-à-dire parallèlement à la paroi 802L de la tranchée 802.

Le fait de prévoir des parois 802L et 802R obliques permet en outre de réduire la longueur du chemin de conduction 116B (figure 3) sous le fond de la région 110G de grille. On diminue ainsi la résistance Ron à l'état passant du transistor 602.

À titre d'exemple, la tranchée 802 présente :
- une largeur maximale Lmax comprise entre 0,4 et 1 µm, par exemple égale à environ 0,5 µm ; et
- une largeur minimale Lmin comprise entre 0,2 et 0,4 µm, par exemple égale à environ 0,3 µm.

À l'issue de cette étape, le gaz d'électrons bidimensionnel 2DEG est discontinu. Plus précisément, la tranchée 802 sépare le gaz d'électrons bidimensionnel 2DEG en deux parties situées de part et d'autre de la tranchée 802. Les couches 106 et 108 sont en outre séparées chacune en deux parties de couches disjointes situées de part et d'autre de la tranchée 802.

La figure 9 est une vue en coupe, schématique et partielle, illustrant encore une autre étape du mode de mise en œuvre du procédé de réalisation du dispositif 600 de la figure 6.

Au cours de cette étape, on réalise les épaulements 308L et 308R. La tranchée 802 est par exemple élargie en partie supérieure uniquement. Dans l'exemple représenté, une épaisseur sensiblement constante de matériau des couches 104, 106 et 108 est retirée le long des parois 802L et 802R de la tranchée 802, à l'exception d'une zone située à proximité du fond 802B. En figure 9, des traits en pointillé situés à l'intérieur de la tranchée 802 symbolisent la position des parois 802L et 802R précédemment formées à l'issue de l'étape de la figure 8.

Les parois 802L et 802R de la tranchée 802 élargie présentent par exemple le même angle α par rapport à une normale à la face supérieure 108T de la couche 108 qu'à l'issue de l'étape de la figure 8. Dans l'exemple représenté, la largeur maximale Lmax de la tranchée 802 élargie est supérieure à celle de la tranchée 802 obtenue à l'issue de l'étape de la figure 8. Dans cet exemple, la largeur minimale Lmin de la tranchée 802 élargie est sensiblement égale à celle de la tranchée 802 précédemment obtenue à l'issue de l'étape de la figure 8.

La figure 10 est une vue en coupe, schématique et partielle, illustrant encore une autre étape du mode de mise en œuvre du procédé de réalisation du dispositif 600 de la figure 6.

Au cours de cette étape, le matériau conducteur 306 est déposé sur la structure du côté de la face 102T du substrat 102. Dans l'exemple représenté, le matériau conducteur 306 forme une couche conductrice continue 1002 revêtant la face supérieure 108T de la couche 108 ainsi que les parois latérales 802L, 802R et le fond 802B de la tranchée 802.

À titre d'exemple, la couche conductrice 1002 est réalisée par une technique de dépôt conforme, par exemple par dépôt chimique en phase vapeur (« Chemical Vapor Déposition » - CVD, en anglais). On évite ou on limite ainsi la présence de défauts cristallins à l'interface entre les couches 104 et 1002, ces défauts étant susceptibles de former des états pièges pour les électrons.

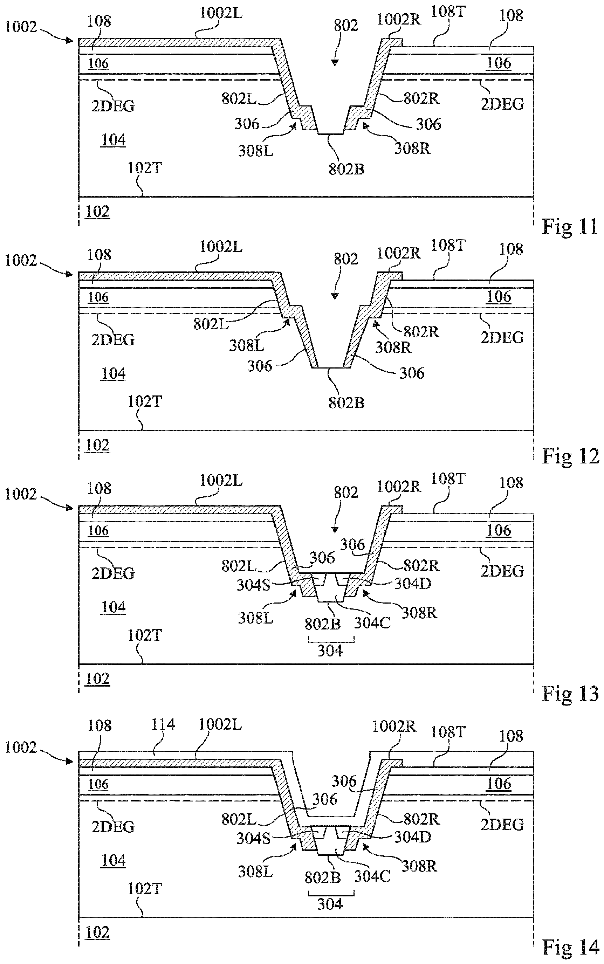

La figure 11 est une vue en coupe, schématique et partielle, illustrant encore une autre étape du mode de mise en œuvre du procédé de réalisation du dispositif 600 de la figure 6.

Au cours de cette étape, la couche conductrice 1002 est gravée de sorte à exposer le fond 802B de la tranchée 802. On élimine pour cela une partie de la couche 1002 revêtant le fond 802B de la tranchée 802. La couche 1002 est ainsi séparée en deux parties disjointes.

On obtient plus précisément, à l'issue de la gravure :
- une partie 1002L de la couche conductrice 1002, revêtant la paroi 802L de la tranchée 802 ; et
- une autre partie 1002R de la couche conductrice 1002, revêtant la paroi 802R de la tranchée 802 et isolée de la partie 1002L.

Dans l'exemple représenté, la couche 1002 est en outre gravée côté future électrode 112D (figure 6), c'est-à-dire à droite dans l'orientation de la figure 11, de sorte à exposer une partie de la face supérieure 108T de la couche 108 située entre la future électrode 112G et la future électrode 112D.

À titre d'exemple, les parties 1002L et 1002R de la couche conductrice 1002 sont réalisées par un procédé de gravure humide. Cela permet notamment d'obtenir une faible rugosité au niveau du fond 802B de la tranchée 802. On réduit ainsi la résistance Ron à l'état passant du dispositif 600.

La gravure humide peut être précédée d'une étape de gravure sèche, par exemple assistée par plasma. Dans ce cas, la gravure humide permet une amélioration d'état de surface, obtenu à l'issue de l'étape de gravure sèche, du fond 802B de la tranchée 802.

À titre de variante, la couche 1002 peut être gravée de sorte que les parties 1002L et 1002R se prolongent sur une partie du fond 802B de la tranchée 802. Dans ce cas, les parties 1002L et 1002R de la couche 1002 revêtent chacune partiellement le fond 802B de la tranchée 802.

On fait toutefois en sorte que les parties 1002L et 1002R de la couche conductrice 1002 soient disjointes. À titre d'exemple, on grave la couche 1002 de manière que la partie 1002L soit séparée de la partie 1002R par une distance suffisante pour éviter tout risque de claquage du fait de la polarisation de l'électrode 112D (figure 6) de drain du dispositif 600. Cette distance est par exemple comprise entre 100 et 300 nm.

Le fait de prolonger les parties 1002L et 1002R de la couche 1002 sur le fond 802B de la tranchée 802 permet d'éviter ou de limiter l'apparition d'effets de bord tendant à accroître la résistance Ron à l'état passant du dispositif 600.

La figure 12 est une vue en coupe, schématique et partielle, illustrant une variante du mode de mise en œuvre du procédé de réalisation du dispositif 600 de la figure 6. La figure 12 illustre plus précisément une variante de la structure obtenue à l'issue de l'étape de la figure 11.

Dans l'exemple représenté, les épaulements 308L et 308R sont approximativement situés au niveau du gaz d'électrons bidimensionnel 2DEG, c'est-à-dire à proximité de l'interface entre les couches 104 et 106. La structure illustrée en figure 12 est par exemple obtenue en gravant les flancs 802L et 802R de la tranchée 802 sur leur partie supérieure uniquement, puis en déposant la couche 1002 du matériau conducteur 306 et en gravant cette couche de façon analogue à ce qui a été exposé précédemment en relation avec la figure 11.

Dans la suite de la description, on suppose que la variante exposée en relation avec la figure 12 n'est pas retenue. Toutefois, l'adaptation des étapes exposées ci-dessous à la variante de la figure 12 est à la portée de la personne du métier.

La figure 13 est une vue en coupe, schématique et partielle, illustrant encore une autre étape du mode de mise en œuvre du procédé de réalisation du dispositif 600 de la figure 6.

Au cours de cette étape, on réalise le transistor 304. À titre d'exemple, une couche en un matériau semiconducteur, par exemple le silicium, est déposée sur la structure du côté de la face supérieure 102T du substrat 102. Cette couche est ensuite gravée pour ne conserver qu'une partie de couche revêtant le fond 802B de la tranchée 802 exposé à l'issue de l'étape de la figure 11. On obtient ainsi la région 304C du transistor 304. Dans l'exemple représenté, la région 304C est située sur et en contact avec une partie du fond 802B de la tranchée 802 et est interposée entre les parties 1002L et 1002R de la couche conductrice 1002.

La région 304C est ensuite dopée pour former les régions 304S de source et 304D de drain du transistor 304. À titre d'exemple, le dopage est effectué par implantation ionique localisée.

Dans l'exemple représenté, le transistor 304 remplit partiellement la tranchée 802. En variante, par exemple si l'on souhaite réaliser un dispositif analogue au dispositif 500 de la figure 5, le transistor 304 comble la tranchée 802.

La figure 14 est une vue en coupe, schématique et partielle, illustrant encore une autre étape du mode de mise en œuvre du procédé de réalisation du dispositif 600 de la figure 6.

Au cours de cette étape, la couche isolante 114 est déposée sur la structure du côté de la face 102T du substrat 102.

À partir de la structure décrite en relation avec la figure 14, on réalise ensuite les électrodes 112S, 112G et 112D afin d'obtenir le dispositif 600 exposé en relation avec la figure 6. À titre d'exemple, les électrodes 112S, 112G et 112D sont obtenues par dépôt puis gravure locale d'une couche métallique (non représentée) revêtant la face supérieure de la couche isolante 114. L'électrode 112G de grille du dispositif 600 (figure 6) est plus précisément formée à l'intérieur de la tranchée 802, les flancs 118L et 118R de l'électrode 112G étant ainsi sensiblement parallèles aux parois 802L et 802R de la tranchée 802.

En variante, le dépôt de la couche isolante 114 est suivi d'une opération de gravure visant à éliminer une partie de la couche isolante 114 revêtant le transistor 304. Cette opération de gravure est par exemple suivie d'une opération de dépôt d'une autre couche conductrice sur la structure, du côté de la face 102T du substrat 102. À titre d'exemple, cette couche isolante est en le même matériau que la couche isolante 114. Dans cette variante, on obtient une surépaisseur de matériau isolant le long des parois 802L et 802R de la tranchée 802 par rapport au fond 802B. Cela procure avantageusement une isolation importante entre l'électrode 112G et la couche 104 permettant de réduire les capacités parasite Cgs et Cgd (figure 1) d'environ 40 à 45 % par rapport au transistor 100. On conserve néanmoins une tension Vth de seuil relativement faible, par exemple de l'ordre de 1 V, et commandée principalement par le fond 118B de l'électrode 112G de grille, contrairement à un cas où le fond 118B de l'électrode 112G du transistor 602 serait revêtu d'une épaisseur de matériau isolant plus importante.

Divers modes de réalisation, modes de mise en œuvre et variantes ont été décrits. La personne du métier comprendra que certaines caractéristiques de ces divers modes de réalisation, modes de mise en œuvre et variantes pourraient être combinées, et d'autres variantes apparaîtront à la personne du métier.

À partir des indications ci-dessus, la personne du métier est notamment capable de prévoir des dispositifs analogues aux dispositifs 300 et 500 mais comportant une connexion entre l'électrode 112S de source et le matériau conducteur 306 côté flanc 118L de l'électrode 112G de grille.

L'adaptation du procédé de réalisation du dispositif 600 décrit en relation avec les figures 7 à 14 afin d'obtenir les dispositifs 300, 400 et 500 des figures 3, 4 et 5 ainsi que les transistors des autres modes de réalisation et variantes des paragraphes ci-dessus, est également à la portée de la personne du métier.

Enfin, la mise en œuvre pratique des modes de réalisation, modes de mise en œuvre et variantes décrits est à la portée de la personne du métier à partir des indications fonctionnelles données ci-dessus. En particulier, la personne du métier est capable de choisir le matériau conducteur 306, ainsi que le matériau et le taux de dopage de chacune des régions 304S, 304D et 304C du transistor 304 en fonction de l'application visée.

## Revendications

1. Dispositif (300 ; 400 ; 500 ; 600) comportant :
- un premier transistor à haute mobilité électronique (302 ; 402 ; 502 ; 602) comprenant :
une première couche (104) en nitrure de gallium ;
une deuxième couche (106) en un premier matériau semiconducteur située sur et en contact avec la première couche, de sorte qu'un gaz d'électrons puisse se former à une interface entre les première et deuxième couches ; et
une première région (110G) de grille traversant la deuxième couche (106) et pénétrant partiellement dans la première couche (104) ; et
- un deuxième transistor (304) situé à l'intérieur de la première région (110G) et comprenant :
des deuxième (304S) et troisième (304D) régions en un deuxième matériau semiconducteur, dopé d'un premier type de conductivité, le deuxième matériau semiconducteur étant différent du nitrure de gallium ; et
une quatrième région (304C) de canal en le deuxième matériau semiconducteur, non intentionnellement dopé ou dopé d'un deuxième type de conductivité opposé au premier type de conductivité, interposée entre les deuxième et troisième régions,
dans lequel un matériau conducteur (306) s'étend le long d'un premier flanc (118L ; 304L) d'une portion verticale de la première région (110G) et contacte la deuxième région (304S).

2. Dispositif selon la revendication 1, dans lequel le deuxième matériau semiconducteur est le silicium.

3. Dispositif selon la revendication 1 ou 2, dans lequel le matériau conducteur (306) s'étend en outre le long d'un deuxième flanc (118R ; 304R), opposé au premier flanc (118L ; 304L), de la portion verticale de la première région (110G) et contacte la troisième région (304D).

4. Dispositif selon l'une quelconque des revendications 1 à 3, dans lequel le premier transistor (302 ; 402 ; 502 ; 602) comporte une première électrode (112G) de grille située au-dessus du deuxième transistor (304) et isolée du deuxième transistor par une troisième couche (114) isolante.

5. Dispositif selon la revendication 4, dans lequel le premier transistor (302 ; 402 ; 502 ; 602) comporte en outre des deuxième (112S) et troisième (112D) électrodes, situées de part et d'autre de la première électrode (112G) et pénétrant partiellement à l'intérieur de la première couche (104), la deuxième électrode étant plus proche de la première électrode que la troisième électrode et le premier flanc (118L ; 304L) étant situé côté deuxième électrode.

6. Dispositif selon la revendication 5, dans lequel le matériau conducteur (306) s'étendant le long du premier flanc (118L ; 304L) se prolonge jusqu'à la deuxième électrode (112S).

7. Dispositif selon la revendication 5 ou 6, dans lequel le matériau conducteur (306) revêt intégralement un flanc de la deuxième région (304S) situé côté deuxième électrode.

8. Dispositif selon l'une quelconque des revendications 4 à 7, dans lequel la première électrode (112G) est plane et située sur et en contact avec la troisième couche (114) isolante, un premier flanc (304L) du deuxième transistor (304) étant revêtu du matériau conducteur (306).

9. Dispositif selon la revendication 8, dans lequel le deuxième transistor (304) occupe la portion verticale de la région (110G) de grille du premier transistor (502), la quatrième région (304C) de canal traversant la deuxième couche (106) et pénétrant partiellement dans la première couche (104).

10. Dispositif selon l'une quelconque des revendications 4 à 7, dans lequel la première électrode (112G) pénètre partiellement à l'intérieur de la première couche (104), un premier flanc (118L) de la première électrode étant revêtu de la troisième couche (114) isolante et du matériau conducteur (306).

11. Dispositif selon la revendication 10, dans lequel le deuxième transistor (304) est situé dans une partie inférieure de la région (110G) de grille du premier transistor (302 ; 402 ; 602).

12. Procédé de fabrication d'un dispositif (300 ; 400 ; 500 ; 600) selon l'une quelconque des revendications 1 à 11, le procédé comprenant les étapes suivantes :
a) former une tranchée (802) à l'intérieur de la première couche (104) en nitrure de gallium ;
b) revêtir un premier flanc (802L) de la tranchée d'une quatrième couche (1002) conductrice ;
c) former le deuxième transistor à l'intérieur de la tranchée ;
d) déposer la troisième couche (114) isolante revêtant la quatrième couche conductrice et le deuxième transistor ; et
e) former la première électrode (112G) de grille du premier transistor au-dessus du deuxième transistor.

13. Procédé selon la revendication 12, dans lequel, à l'étape b), un deuxième flanc (802R) de la tranchée (802), opposé au premier flanc (802L), est revêtu de la quatrième couche (1002) conductrice.

14. Procédé selon la revendication 12 ou 13, dans lequel, à l'étape c), le deuxième transistor (304) remplit partiellement la tranchée (802).

15. Procédé selon la revendication 12 ou 13, dans lequel, à l'étape c), le deuxième transistor (304) comble la tranchée (802).
